# EUROPEAN PATENT APPLICATION

(11) **EP 4 539 106 A1**
(43) Date of publication of application: **16.04.2025**
(21) Application number: 23831314.2
(22) Date of filing: 23.06.2023
(51) Int. Cl.: H01L 21/316, H01L 21/304, H01L 21/3065

(54) **PROCESSING METHOD FOR SILICON CARBIDE SINGLE CRYSTAL SUBSTRATE, SILICON CARBIDE SINGLE CRYSTAL SUBSTRATE PROCESSING SYSTEM, AND REPLENISHING LIQUID**

(30) Priority: 30.06.2022 JP 2022106471
(71) Applicant: TOKYO OHKA KOGYO CO., LTD., Kawasaki-shi, Kanagawa 211 0012 (JP)
(72) Inventor: GO, Choitsu, Kawasaki-shi, Kanagawa 211-0012 (JP); SHIMURA, Eiichi, Kawasaki-shi, Kanagawa 211-0012 (JP); WADA, Yukihisa, Kawasaki-shi, Kanagawa 211-0012 (JP)
(74) Representative: Plasseraud IP
(86) International application number: PCT/JP2023/023381
(87) International publication number: WO 2024/004872

(57) **Abstract**

Provided are a processing method for a silicon carbide single crystal substrate whereby it is possible to perform thick film processing of a desired surface of a SiC single crystal substrate in a short time under mild conditions such as room temperature, and a silicon carbide single crystal substrate processing system that can be applied to the processing method. The processing method for a silicon carbide single crystal substrate includes: a step (A) in which a silicon carbide single crystal substrate having a silicon carbide semiconductor layer epitaxially grown on a first main surface is provided; a step (B) in which the first main surface is brought into contact with an electrolyte solution containing fluorine anions while applying a voltage to the silicon carbide single crystal substrate as an anode, anodization is performed, and a film containing oxygen is thereby formed on the first main surface; and a step (C) in which the film is removed by dry etching, ashing, or CMP.

## Description

### TECHNICAL FIELD

The present invention relates to a silicon carbide single crystal substrate treating method, a silicon carbide single crystal substrate treating system, and a replenishing liquid.

### BACKGROUND ART

Since SiC (silicon carbide), a semiconductor material, has a wider band gap than Si (silicon), and is widely used as a substrate for devices at present, studies have been conducted to manufacture power devices, high-frequency devices, high-temperature operating devices, and the like by using a silicon carbide single crystal substrate.

In order to manufacture semiconductor elements (transistors and the like), a smooth semiconductor substrate having a desired thickness is required. Such a substrate is manufactured by a process such as polishing or etching. Silicon carbide single crystal substrates for such applications are required to have high treating accuracy in terms of flatness of the substrate, smoothness of the substrate surface, and the like. However, since silicon carbide is generally high in hardness and excellent in corrosion resistance, the processability when such a substrate is manufactured is poor. It is, thus, difficult to obtain a silicon carbide single crystal substrate having high processing accuracy. Therefore, conventionally, a method of oxidizing both surfaces of a silicon carbide single crystal substrate by thermal oxidation in a batch at 800 to 1200°C for 1 to 5 hours, a method of oxidizing a silicon carbide single crystal substrate by O₂ plasma treatment at 100 to 300°C, and the like have been studied.

Because of its chemical stability, silicon carbide single crystal substrates are poorly soluble in ordinary acids, alkali aqueous solutions, and the like. Patent Document 1 proposes a method of treating a silicon carbide single crystal substrate by electrolytic etching using hydrofluoric acid (HF) as an electrolyte solution. Patent Document 2 proposes a method of treating a silicon carbide single crystal substrate by electrochemical etching or photoelectrochemical etching using an etchant containing hydrofluoric acid, nitric acid, and a surfactant. Patent Document 3 proposes a method of treating a silicon carbide single crystal substrate by photoelectrochemical etching while irradiating light of a specific wavelength and a specific intensity using an etchant containing hydrofluoric acid and nitric acid.

### Citation List

### Patent Document

Patent Document 1: Japanese Patent No. 5560774
Patent Document 2: Japanese Unexamined Patent Application, Publication No. 2021-44271
Patent Document 3: Japanese Patent No. 6821948

### DISCLOSURE OF THE INVENTION

### Problems to be Solved by the Invention

However, as a result of study by the present inventors, in a treating method such as electrolytic etching as described in Patent Documents 1 to 3, etching of a silicon carbide single crystal substrate was not sufficient in some cases. In addition, in a treating method such as electrolytic etching as described in Patent Documents 1 to 3, it was sometimes difficult to form a flat surface with good roughness on a desired surface of an etched SiC substrate, and there was room for improvement.

The present invention has been made in view of the above circumstances, and an object of the present invention is to provide a silicon carbide single crystal substrate treating method, the method being capable of controlling film thickness of a desired surface of the silicon carbide single crystal substrate in a short time under mild conditions such as room temperature, and a silicon carbide single crystal substrate treating system applicable to the treating method.

### Means for Solving the Problems

In order to solve the above problems, the present invention adopts the following configuration.
(1) A method for treating a silicon carbide single crystal substrate, including: a step (A) of providing a silicon carbide single crystal substrate having a silicon carbide semiconductor layer epitaxially grown on a first main surface thereof, a step (B) of forming a film including oxygen on the first main surface by anodization using the silicon carbide single crystal substrate as an anode and applying a voltage while bringing the first main surface into contact with an electrolyte solution containing a fluorine anion, and a step (C) of removing the film by any of dry etching, ashing, or CMP.
(2) The method for treating a silicon carbide single crystal substrate as described in (1), in which a fluorine anion-supply source is at least one selected from the group consisting of hydrofluoric acid, ammonium fluoride, a mixture of hydrofluoric acid and ammonium fluoride, tetramethylammonium fluoride, and hexafluorosilicic acid.
(3) The method for treating a silicon carbide single crystal substrate as described in (1) or (2), in which the electrolyte solution contains at least one selected from the group consisting of an acid and hydrogen peroxide.
(4) The method for treating a silicon carbide single crystal substrate as described in (3), in which the acid is at least one selected from the group consisting of a carboxylic acid, a sulfonic acid, a phosphonic acid, an inorganic acid, and periodic acid.
(5) The method for treating a silicon carbide single crystal substrate as described in (1), in which the electrolyte solution contains at least one selected from the group consisting of sulfuric acid, methanesulfonic acid, an alkylsulfonic acid, phosphoric acid, polyphosphoric acid, and an alkylphosphonic acid.
(6) The method for treating a silicon carbide single crystal substrate as described in any one of (1) to (5), in which the electrolyte solution contains at least one alkali selected from the group consisting of an inorganic alkali and an organic alkali.
(7) The method for treating a silicon carbide single crystal substrate as described in (6), in which the alkali is at least one selected from the group consisting of a quaternary ammonium hydroxide salt, a tertiary amine, a secondary amine, a primary amine, and ammonia.
(8) The method for treating a silicon carbide single crystal substrate as described in any one of (1) to (7), in which the electrolyte contains an oxidizing agent.
(9) The method for treating a silicon carbide single crystal substrate as described in any one of (1) to (8), in which the dry etching or the ashing includes etching with a gas containing a halogen atom.
(10) The method for treating a silicon carbide single crystal substrate as described in any one of (1) to (9), in which the electrolyte solution contains at least one antifoaming agent selected from the group consisting of an organic solvent and a surfactant.
(11) The method for treating a silicon carbide single crystal substrate as described in (10), in which the antifoaming agent contains an alcohol solvent.
(12) The method for treating a silicon carbide single crystal substrate as described in any one of (1) to (11), in which the step (B) is performed at a liquid temperature of the electrolyte solution of 300°C or less.
(13) The method for treating a silicon carbide single crystal substrate as described in any one of (1) to (12), further including a step (D) of replenishing the electrolyte solution with a replenishing liquid having a higher fluorine anion concentration than the electrolyte solution.
(14) A silicon carbide single crystal substrate treating system including: an anode that is a silicon carbide single crystal substrate having an epitaxially grown silicon carbide semiconductor layer on a first main surface thereof; a cathode opposed to the silicon carbide single crystal substrate; an electrolyte solution interposed between the silicon carbide single crystal substrate and the cathode, being in contact with the first main surface and the cathode, and containing a fluorine anion; a power source device connected between the anode and the cathode and causing an anodization reaction at an interface of the first main surface by application of a voltage, and a treatment device that removes a film containing oxygen formed on the first main surface by dry etching, ashing or CMP.
(15) A replenishing liquid for use in replenishing the electrolyte solution for use in the method for treating a silicon carbide single crystal substrate as described in any one of (1) to (13), in which the replenishing liquid has a higher fluorine anion concentration than the electrolyte solution.

### Effects of the Invention

According to the present invention, it is possible to provide a silicon carbide single crystal substrate treating method capable of controlling film thickness of a desired surface of the silicon carbide single crystal substrate in a short time under a mild condition such as room temperature, and a silicon carbide single crystal substrate treating system applicable to the treating method.

### BRIEF DESCRIPTION OF THE DRAWINGS

[FIG. 1] FIG. 1 is a schematic diagram showing an example of a silicon carbide single crystal substrate treating system according to the present embodiment.
[FIG. 2A] FIG. 2A is a schematic view of a silicon carbide single crystal substrate treating device used in Examples.
[FIG. 2B] FIG. 2B is a top view of a cell of the silicon carbide single crystal substrate treating device used in Examples.

### PREFERRED MODE FOR CARRYING OUT THE INVENTION

### <Method for Treating Silicon Carbide Single Crystal Substrate>

The method for treating a silicon carbide single crystal substrate according to the present embodiment includes a step (A) of providing a silicon carbide single crystal substrate having a silicon carbide semiconductor layer epitaxially grown on a first main surface thereof,
a step (B) of forming a film containing oxygen on the first main surface by anodization using the silicon carbide single crystal substrate as an anode and applying a voltage while bringing the first main surface into contact with an electrolyte solution containing a fluorine anion, and a step (C) of removing the film by any of dry etching, ashing, or CMP. In the method for treating a silicon carbide single crystal substrate according to the present embodiment, a porous film that can be removed by etching can be formed on the silicon carbide single crystal substrate. The method for treating a silicon carbide single crystal substrate according to the present embodiment may or may not further include a step (D) of replenishing the electrolyte solution with a replenishing liquid having a higher fluorine anion concentration than the electrolyte solution. In the present embodiment, the "main surface" refers to a main surface of the substrate, and the substrate preferably has a first main surface and a second main surface (for example, a back surface). The present invention also relates to a method for forming a porous film including the method for treating a silicon carbide single crystal substrate according to the present embodiment. Hereinafter, each step will be described.

### [Step (A)]

The method for providing a silicon carbide single crystal substrate having a silicon carbide semiconductor layer epitaxially grown on the first main surface (hereinafter also simply referred to as "SiC single crystal substrate") is not particularly limited, and it is possible to provide an industrially available SiC single crystal substrate, or it is possible to make a silicon carbide semiconductor layer epitaxially grow on at least one main surface of a SiC single crystal substrate by a known method and provide the resulting SiC single crystal substrate.

In the present embodiment, the SiC single crystal substrate may have the silicon carbide semiconductor layer epitaxially grown only on the first main surface, or may have the silicon carbide semiconductor layers epitaxially grown on both the first main surface and the second main surface.

### [Step (B)]

In the step (B), a film including oxygen is formed on a first main surface of a silicon carbide single crystal substrate by anodization using the silicon carbide single crystal substrate as an anode and applying a voltage while contacting the first main surface of the SiC single crystal substrate with an electrolyte solution containing a fluorine anion. Specifically, the first main surface of the SiC single crystal substrate as an anode is brought into contact with an electrolyte solution containing a fluorine anion, and a surface (a surface other than a liquid contact surface) of the SiC single crystal substrate that is not in contact with the electrolyte solution and a cathode are electrically connected to each other with a DC power source device interposed therebetween. Then, a voltage is applied between the single crystal SiC substrate and the cathode by using a DC power source device, whereby an anodization treatment is performed on the first main surface of the single crystal SiC substrate in an in-plane uniform manner to form a film including oxygen on the first main surface. When the SiC single crystal substrate has silicon carbide semiconductor layers epitaxially grown on both the first main surface and the second main surface thereof, the anodization treatment may be performed in an in-plane uniform manner across both the entire main surfaces of the SiC single crystal substrate, one side at a time.

During the anodization treatment, the reactions occurring at the anode and cathode are presumed to be as follows.
Anode: SiC + 4H₂O → SiO₂ + CO₂ + 8H⁺ + 8e⁻
Cathode: 8H⁺ + 8e⁻ → 4H₂

In the anodization treatment, silicon having a lower ionization tendency than carbon is preferentially oxidized. Silicon dioxide produced by anodizing silicon is etched by an electrolyte solution containing fluorine anions. Therefore, a carbon-rich SiOC film is formed on the surface of the first main surface of the silicon carbide single crystal substrate as the reaction in the anodization progresses. Further, the electrolyte solution containing fluorine anions infiltrates into the SiOC film to form pores. As a result, a film containing oxygen (hereinafter simply referred to as "porous film") is formed on the first main surface.

As the cathode in the step (B), a metal having a smaller ionization tendency than hydrogen can be used. Specifically, a metal such as copper, silver, palladium, platinum, or gold can be used as the cathode. Carbon that is stable in solutions can also be used as a cathode.

In the step (B), the temperature of the electrolyte solution during the anodization is not particularly limited, but is preferably 300°C or less, more preferably 5 to 60°C, and still more preferably 10 to 40°C. When the treatment temperature of the anodization is within the above preferable range, a low boiling point solvent such as an aqueous solvent is easy to use, and the number of types of solvents that can be used is easy to increase. In addition, member selection of the device, safety measures and the like tend to be simple. In addition, it is easy to save power (cost) during manufacturing, and it is easy to shorten cooling time.

In the step (B), the treatment time for anodization is not particularly limited, but is preferably 2 seconds to 30 minutes, more preferably 5 seconds to 20 minutes, and still more preferably 10 seconds to 10 minutes. When the treatment time of the anodization is within the above preferable range, it is easy to form a porous film having a desired film thickness on the first main surface with a high yield.

In the step (B), the voltage to be applied for anodization is not particularly limited, but is preferably 1 to 60 V, more preferably 3 to 30 V, and still more preferably 5 to 20 V. When the applied voltage is within the above preferable range, it is easy to form a porous film having a desired film thickness on the first main surface.

The electrolyte solution to be used in the step (B) is not particularly limited as long as it contains a fluorine anion, but from the viewpoint of roughness, a stock solution of the electrolyte solution preferably has a viscosity of 1.0 mPa·s or more and 10 mPa·s or less at 20°C, and an aqueous solution preferably has a conductivity of 0.1 mS/cm or more and 900 mS/cm or less.

The electrolyte solution to be used in the step (B) preferably contains, as a fluorine anion-supply source, at least one selected from the group consisting of hydrofluoric acid, ammonium fluoride, a mixture of hydrofluoric acid and ammonium fluoride, tetramethylammonium fluoride, and hexafluorosilicic acid, and more preferably contains hydrofluoric acid and a mixture of hydrofluoric acid and ammonium fluoride. When the electrolyte solution contains a fluorine anion-source, a porous film is easily formed on the surface of the SiC substrate, and the porous film is easily removed in the step (C).

Examples of the electrolyte solution include aqueous solutions containing any of the following components (E1) to (E3) :
component (E1): at least one selected from the group consisting of hydrofluoric acid, ammonium fluoride, a mixture of hydrofluoric acid and ammonium fluoride,
tetramethylammonium fluoride, and hexafluorosilicic acid,
(E2): at least one selected from the group consisting of an acid and hydrogen peroxide, and
(E3): at least one alkali selected from the group consisting of an inorganic alkali and an organic alkali.
When the electrolyte solution contains the component (E2) and/or the component (E3), the electrolyte solution may contain a fluorine anion-supply source, and preferably contains the component (E1) as well.

As the component (E1), hydrofluoric acid or a mixture of hydrofluoric acid and ammonium fluoride is preferable.

As the acid of the component (E2), at least one selected from the group consisting of a carboxylic acid, a sulfonic acid, a phosphonic acid, an inorganic acid, and periodic acid is preferable. As the carboxylic acid, formic acid, citric acid, malonic acid, acetic acid, benzoic acid, lactic acid, malic acid, propionic acid, butyric acid, and valeric acid are preferable, and citric acid and acetic acid are more preferable. As the sulfonic acid, sulfuric acid, methanesulfonic acid, ethanesulfonic acid, benzenesulfonic acid, and p-toluenesulfonic acid are preferable, and an aqueous solution of sulfuric acid or methanesulfonic acid is more preferable. As the phosphonic acid, phosphoric acid, polyphosphoric acid, an alkyl phosphonic acid (such as butyl phosphonic acid, etc.), propylphosphonic acid, hexylphosphonic acid, and phenylphosphonic acid are preferable, and phosphoric acid and polyphosphoric acid are more preferable. As the inorganic acid, sulfuric acid, phosphoric acid, polyphosphoric acid, nitric acid, nitrous acid, sulfurous acid, phosphorous acid, hydrochloric acid, chloric acid, and perchloric acid are preferable, and sulfuric acid, phosphoric acid, and nitric acid are more preferable. Among these, as the component (E2), acetic acid, sulfuric acid, phosphoric acid, polyphosphoric acid, and nitric acid are preferable, and sulfuric acid and phosphoric acid are more preferable. As the component (E2), sulfuric acid, phosphoric acid, and orthoperiodic acid are preferable from the viewpoint of improvement in pattern shapes.

As the component (E3), at least one selected from the group consisting of a quaternary ammonium hydroxide salt, a tertiary amine, a secondary amine, a primary amine, and ammonia is preferable.

Examples of the quaternary ammonium hydroxide salt include tetraethylammonium hydroxide (TEAH), tetramethylammonium hydroxide (TMAH), tetrapropylammonium hydroxide (TPAH), dimethylbis(2-hydroxyethyl)ammonium hydroxide (DMEMAH), tetrabutylammonium hydroxide (TBAH), tetrapropylammonium hydroxide (TPAH), tris(2-hydroxyethyl)methylammonium hydroxide (THEMAH), choline, dimethyldiethylammonium hydroxide, tetraethanolammonium hydroxide, benzyltrimethylammonium hydroxide, benzyltriethylammonium hydroxide, benzyltributylammonium hydroxide are preferable, and tetramethylammonium hydroxide (TMAH) is more preferable.

Examples of the tertiary amine include alkylamines such as trimethylamine, triethylamine, tripropylamine, tributylamine, triisobutylamine, dimethylethylamine, dimethylpropylamine, allyldiethylamine, dimethyl-n-butylamine, and diethylisopropylamine; cycloalkylamines such as tricyclopentylamine and tricyclohexylamine and the like, 4-dimethylaminopyridine, N,N,N',N'-tetramethylethylenediamine, N,N,N',N'-tetraethylethylenediamine, N,N,N',N'-tetramethyl-1,3-diaminopropane, N,N,N',N'-tetramethyl-1,3-diaminobutane, N',N'-tetramethyl-1,4-diaminobutane, N,N,N',N'-tetramethylphenylenediamine, 1,2-dipiperidinoethane, N-methylpiperidine, N-methylpyrrolidine, and N-methylmorpholine are preferable, and tributylamine is more preferable.

Examples of the preferable secondary amine include alkylamines such as dimethylamine, diethylamine, methylethylamine, dipropylamine, diisopropylamine, dibutylamine, diisobutylamine, and butylmethylamine; cycloalkylamines such as N,N-dicyclohexylamine, N-cyclopentylcyclohexanamine; alkoxyamines such as methoxy(methylamine) and N-(2-methoxyethyl)ethylamine; piperidine, 2-pipecolin, 3-pipecolin, 4-pipecolin, 2,6-dimethylpiperidine, 3,5-dimethylpiperidine, pyrrolidine, 2-methylpyrrolidine, 3-methylpyrrolidine, morpholine, 2-methylmorpholine, 3-methylmorpholine, 2-methylpiperazine, 2,3-dimethylpiperazine, 2,5-dimethylpiperazine, N,N'-dimethylethanediamine, N,N'-dimethylpropanediamine, N,N'-diethylethylenediamine, N,N'-diethylpropanediamine, and N,N'-diisopropylethylenediamine and dibutylamine is more preferable.

Examples of preferable primary amine include alkylamines such as methylamine, ethylamine, propylamine, n-butylamine, isopropylamine, and tert-butylamine; cycloalkylamines such as cyclopentylamine, cyclohexylamine, and cyclohexanemethylamine; alkoxyamines such as methoxyethylamine, methoxypropylamine, methoxybutylamine, ethoxypropylamine, and propoxypropylamine, other hydroxylamines, 2-(2-aminoethylamino)ethanol, ethylenediamine, butane 1,4-diamine, 1,3-propanediamine, 1,6-hexanediamine, pentane-1,5-diamine, and monoethanolamine, and n-butylamine and monoethanolamine are more preferable.

Examples of the component (E3) include alkali metal salts such as potassium chloride. Among them, monoethanolamine and TMAH are preferable as the component (E3).

The electrolyte solution may be used alone or in combination of two or more types thereof. Among them, as the electrolyte solution, the component (E1) or a combination of the component (E1) and at least one of the component (E2) or (E3) is preferable, a combination the component (E1) and at least one of the component (E2) or (E3) is more preferable, and a combination of the component (E1) and the component (E2) is still more preferably, from the viewpoint of forming a porous film having a desired film thickness at a low voltage in a short time.

The concentration of the electrolyte solution is not particularly limited as long as it is an aqueous solution containing any of the components (E1) to (E3), but is preferably 0.0001 to 99.99% by mass, more preferably 0.001 to 90% by mass, and still more preferably 0.002 to 50% by mass. The electrolyte solution (aqueous solution) having a concentration within the above preferable range is easy to form a porous film having a desired film thickness on the main surface of the single crystal SiC substrate.

In this embodiment, the electrolyte solution may include an oxidizing agent. Examples of the oxidizing agent include H₂O₂, nitric acid, hydrochloric acid, periodic acid, peracetic acid, peroxodisulfuric acid, and hypochlorous acid. The content of the oxidizing agent is not particularly limited, but is preferably 0.0001 mass% to 99.00 mass%, more preferably 0.001 mass% to 90 mass%, and still more preferably 0.002 mass% to 50 mass%, based on the total amount of the electrolyte solution. When the content of the oxidizing agent is within the above preferable range, a porous film is easily formed on the surface of the SiC substrate, and the porous film is easily removed in the step (C).

In the present embodiment, the electrolyte solution may contain at least one antifoaming agent selected from the group consisting of an organic solvent and a surfactant.

The organic solvent is preferably an alcohol solvent. Examples of the alcohol solvent include alcohols (monohydric alcohols) such as ethanol, 1-propanol, isopropanol, 1-butanol, 2-butanol, isobutanol, 3-methyl-1-butanol, tert-butyl alcohol, 1-pentanol, 2-pentanol, 1-hexanol, 1-heptanol, 1-octanol, 1-decanol, 2-hexanol, 2-heptanol, 2-octanol, 3-hexanol, 3-heptanol, 3-octanol, 4-octanol, 3-methyl-3-pentanol, cyclopentanol, 2,3-dimethyl-2-butanol, 3,3-dimethyl-2-butanol, 2-methyl-2-pentanol, 2-methyl-3-pentanol, 3-methyl-2-pentanol, 3-methyl-3-pentanol, 4-methyl-2-pentanol, 4-methyl-3-pentanol, cyclohexanol, 5-methyl-2-hexanol, 4-methyl-2-hexanol, 4,5-dimethyl-2-hexanol, 6-methyl-2-heptanol, 7-methyl-2-octanol, 8-methyl-2-nonal, 9-methyl-2-decanol, 3-methoxy-1-butanol, and 3-methoxy-3-methyl-1-butanol; glycol-based solvents such as ethylene glycol, diethylene glycol, propylene glycol and triethylene glycol; polyhydric alcohol solvents such as glycerin; glycol ether solvents containing a hydroxyl group such as ethylene glycol monomethyl ether, propylene glycol monomethyl ether (PGME; also known as 1-methoxy-2-propanol), diethylene glycol monomethyl ether, triethylene glycol monoethyl ether, methoxymethyl butanol, ethylene glycol monoethyl ether, ethylene glycol monopropyl ether, ethylene glycol monobutyl ether, propylene glycol monoethyl ether, propylene glycol monopropyl ether, propylene glycol monobutyl ether, propylene glycol monophenyl ether, and dipropylene glycol dimethyl ether.

Examples of the organic solvent other than the alcohol solvent include propylene glycol monomethyl ether acetate (PEGEMA), acetic acid, ethyl acetate, propyl acetate, isopropyl acetate, butyl acetate, cyclohexanone, DMAC, DMSO, NMP, 2-pyrrolidone, sulfolane, propylene carbonate, acetone, cyclohexanone, and N-methylmorpholine-N-oxide.

Examples of the surfactant include a nonionic surfactant, an anionic surfactant, a cationic surfactant, and an amphoteric surfactant.

Examples of the nonionic surfactant include a polyalkylene oxide alkylphenyl ether-based surfactant, a polyalkylene oxide alkyl ether-based surfactant, a block polymer-based surfactant consisting of polyethylene oxide and polypropylene oxide, a polyoxyalkylene distyrened phenyl ether-based surfactant, a polyalkylene tribenzylphenyl ether-based surfactant, and an acetylene polyalkylene oxide-based surfactant.

Examples of the anionic surfactant include alkyl sulfonic acid, alkyl benzene sulfonic acid, alkyl naphthalene sulfonic acid, alkyl diphenyl ether sulfonic acid, fatty acid amide sulfonic acid, polyoxyethylene alkyl ether carboxylic acid, polyoxyethylene alkyl ether acetic acid, polyoxyethylene alkyl ether propionic acid, alkyl phosphonic acid, and salts of fatty acids. Examples of the "salt" include an ammonium salt, a sodium salt, a potassium salt, and a tetramethylammonium salt.

Examples of the cationic surfactant include alkylpyridium-based surfactants and quaternary ammonium saltbased surfactants.

Examples of the amphoteric surfactant include a betaine surfactant, an amino acid surfactant, an imidazoline surfactant, and an amine oxide surfactant.

The antifoaming agents may be used alone or in combination of two or more types thereof. The content of the antifoaming agent is not particularly limited, but is preferably 0.0001% by mass to 50% by mass, more preferably 0.0002% by mass to 10% by mass, still more preferably 0.002% by mass to 1% by mass, and particularly preferably 0.002% by mass to 0.2% by mass based on the total amount of the electrolyte solution. When the content of the antifoaming agent is within the above preferable range, it is easy to prevent bubble formation on the surface of the SiC single crystal substrate after anodization. Thus, a porous film having a desired film thickness can be easily formed in an in-plane uniform manner across the first main surface.

In the present embodiment, the electrolyte solution preferably has a final current density of 0.01 mA/cm² or more, more preferably 0.1 mA/cm² or more, still more preferably 0.5 mA/cm² or more, and particularly preferably 1.0 mA/cm² or more, the final current density being a current density, a variation width of which is in a range of ±3 mA/cm² continuously for 60 seconds after the voltage is applied in the step (B). The upper limit of the final current density is not particularly limited, and examples thereof include 150 mA/cm² or less, 100 mA/cm² or less, and 80 mA/cm² or less. When the final current density is within the above preferable range, the formation of a porous film more preferentially occurs than the oxidation reaction of the electrolyte solution.

The thickness of the porous film formed in the step (B) is not particularly limited, and can be appropriately adjusted according to the purpose. In the present embodiment, for example, a porous film having a film thickness of 1 to 20,000 nm can be formed. The thickness of the porous film is preferably 10 to 15,000 nm, and more preferably 20 to 10,000 nm.

### [Step (C)]

In the step (C), the porous film formed in the step (B) is removed by any of dry etching, ashing, or CMP (chemical mechanical polishing). Through the step (C), a flat surface can be formed on a desired surface of the SiC single crystal substrate. Treatment conditions for removal are not particularly limited, and known treatment conditions can be employed.

In the case of dry etching or ashing in the step (C), it is preferable to perform the etching treatment with a gas containing halogen atoms from the viewpoint of performing an etching treatment more efficiently. Examples of a gas containing a fluorine atom include CF₄, CHF₃, and SF₆ gas. Examples of a gas containing a chlorine atom include Cl₂ gas and BCl₃ gas.

### [Step (D)]

In the step (D), the electrolyte solution is replenished with a replenishing liquid having a higher fluorine anion concentration than the electrolyte solution. The timing of performing the step (D) is not particularly limited, but when the concentration of the electrolyte solution becomes lower than before the anodization is started, the replenishing liquid may be added to the electrolyte solution. For example, when the electrolyte is an acid, the concentration of hydrogen ions in the replenishing liquid is made higher than that in the electrolyte solution. Further, when the electrolyte is an alkali, the concentration of hydroxide ions in the replenishing liquid is made higher than the concentration in the electrolyte solution. In the present embodiment, it is preferable to add the replenishing liquid to the electrolyte solution when the fluorine anion concentration of the electrolyte solution becomes 3% or more lower than that before the start of anodization.

According to the method for treating a SiC single crystal substrate of the present embodiment, it is possible to control film thickness of a desired surface of a SiC single crystal substrate in a short time under mild conditions such as room temperature. In addition, in the method for treating a SiC single crystal substrate according to the present embodiment, a metal-free high-purity solution having high stability that can be used in semiconductors can be used. In addition, a porous film having a desired film thickness can be formed in an in-plane uniform manner across the SiC surface, and by etching the porous film, it is possible to etch the SiC substrate while maintaining a smooth surface. In addition, the method for treating a SiC single crystal substrate of the present embodiment can eliminate a treatment such as light irradiation during the anodization, it is possible to simplify manufacturing equipment. Therefore, according to the method for treating a SiC single crystal substrate of the present embodiment, it is possible to decrease cost of the entire manufacturing process and increase the yield.

### <Silicon Carbide Single Crystal Substrate Treating System>

A silicon carbide single-crystal substrate treating system according to the present embodiment includes an anode that is a silicon carbide single crystal substrate having a silicon carbide semiconductor layer epitaxially grown on a first main surface thereof; a cathode opposed to the silicon carbide single crystal substrate; an electrolyte solution interposed between the silicon carbide single crystal substrate and the cathode, being in contact with the first main surface and the cathode, and containing a fluorine anion; a power source device connected between the anode and the cathode and causing anodization at an interface of the first main surface by application of a voltage, and a treatment device that removes the porous film formed on the first main surface by any of dry etching, ashing, or CMP.

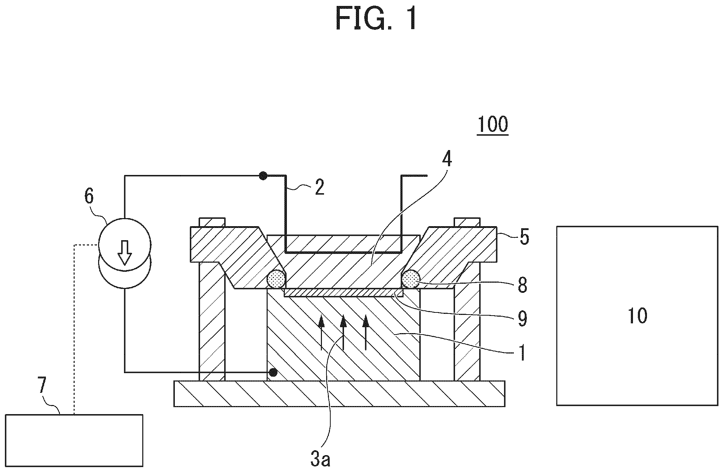

Hereinafter, the silicon carbide single crystal substrate treating system according to the present embodiment will be described with reference to the drawings. FIG. 1 is a schematic diagram showing an example of the silicon carbide single crystal substrate treating system according to the present embodiment. A silicon carbide single crystal substrate treating system 100 includes an electrolysis bath 5 containing an electrolyte solution 4, a power source 6 and a power source controller 7, a cathode (silver, palladium, platinum, gold, carbon, etc.) 2 connected to the power source and a workpiece 1 to be subjected to anodization as an anode (in this case, the SiC single crystal substrate is an anode 1) connected to the power source, the electrolyte solution 4 interposed between the anode 1 and the cathode 2, and an etching treatment device 10. In the case of this example, a seal 8 is provided between the electrolysis bath 5 and the anode 1 so that the electrolyte solution 4 does not leak out, but this is for preventing the electrolyte solution 4 from being brought into contact with a surface other than the surface to be treated of the anode 1, and the seal 8 is not always necessary depending on the device configuration. When a current flows through the SiC single crystal substrate (anode 1) and the cathode 2 via the power source controlling device 7, a current 3a flows toward the substrate surface to cause an anodization reaction, regardless of whether the SiC single crystal substrate is a p-type or n-type substrate. A porous film 9 is formed on the SiC single crystal substrate by the anodization reaction.

In the present embodiment, the SiC single crystal substrate (anode 1) has a silicon carbide semiconductor layer epitaxially grown on the first main surface. The SiC single crystal substrate is the same as the SiC single crystal substrate in the above-described method for treating a silicon carbide single crystal substrate.

In the present embodiment, the electrolyte solution 4 contains a fluorine anion, and is the same as the electrolyte solution in the above-described method for treating a silicon carbide single crystal substrate. The concentration of the electrolyte solution 4 may be adjusted immediately before the electrolyte solution 4 is brought into contact with the SiC single crystal substrate (anode 1), or the electrolyte solution 4 may be used by adding a chemical solution having a high concentration. Further, even when the electrolyte solution 4 contains impurities such as a substance eluted from the SiC single crystal substrate, with which the electrolyte solution 4 came into contact, the electrolyte solution 4 may be used as it is, or the impurities may be removed in the circulation process. When the electrolyte solution is used by adding a chemical solution having a high concentration, the replenishment is carried out using a replenishing liquid, which has an electrolyte concentration higher than the electrolyte solution. For example, when the electrolyte is an acid, the concentration of hydrogen ions in the replenishing liquid should be set higher than the concentration in the electrolyte solution. When the electrolyte is an alkali, the concentration of hydroxide ions in the replenishing liquid should be set higher than the concentration in the electrolyte solution.

In the present embodiment, treatment conditions for the anodization are the same as those for the anodization in the above-described method for treating a silicon carbide single crystal substrate.

The SiC single crystal substrate (anode 1) after the anodization treatment is conveyed to a porous film removal treatment device 10 and subjected to the porous film removal treatment. The porous film removal treatment device 10 is not particularly limited as long as the porous film can be removed by any of dry etching, ashing, or CMP (chemical mechanical polishing), and a known device can be used. The treatment conditions for removing the porous film are the same as the treatment conditions for removing the porous film in the above-described method for treating a silicon carbide single crystal substrate.

According to the silicon carbide single crystal substrate treating system of the present embodiment, it is possible to control film thickness of a desired surface of a SiC single crystal substrate in a short time under mild conditions such as room temperature. In addition, in the silicon carbide single crystal substrate treating system according to the present embodiment, a metal-free high-purity solution having high stability that can be used in semiconductors can be used. Further, the silicon carbide single crystal substrate treating system of the present embodiment can eliminate a treatment such as light irradiation during the anodization, it is possible to simplify manufacturing equipment. Therefore, according to the silicon carbide single crystal substrate treating system of the present embodiment, it is possible to decrease cost of the entire manufacturing process and increase the yield. In addition, the SiC single crystal substrate obtained by the silicon carbide single crystal substrate treating system according to the present embodiment can be subjected to a high accuracy processing treatment of the porous film due to the SiC single crystal substrate after the anodization treatment being etched.

The embodiment shown in FIG. 1 is explained by exemplifying the configuration in which the anodization is carried out by horizontally disposing the SiC single crystal substrate (anode 1) on the bottom surface of the electrolysis bath 5, but the silicon carbide single crystal substrate treating system according to the present embodiment is not limited thereto. For example, in a case where a plurality of SiC single crystal substrates are subjected to the anodization treatment at the same time, the anodization treatment may be carried out by providing a substrate holding mechanism, while holding the SiC single crystal substrates so that only a surface to be treated of each SiC single crystal substrate comes into contact with the electrolyte solution 4. In another possible configuration, the anodization treatment may be performed, by disposing the SiC single crystal substrate perpendicular to the bottom surface of the electrolysis bath 5.

### EXAMPLES

Hereinafter, the present invention will be described in more detail with reference to Examples, but will not be limited thereto.

### (Preparation of Electrolyte Solution)

In each test example, an aqueous electrolyte solution having the composition shown in Table 1 was prepared.

### [Treatment (1) of SiC Substrate]

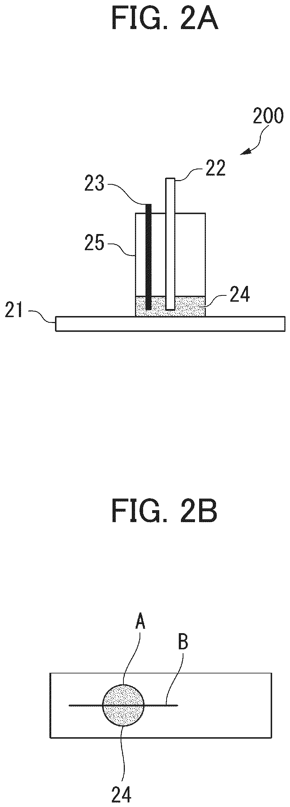

In potentiostat R600+ (manufactured by GAMRY), a SiC wafer (having a silicon carbide semiconductor layer epitaxially grown on the first main surface, manufactured by Showa Denko) was used as an anode (21), an Ag/AgCl electrode was used as a reference electrode (22), and a Pt electrode was used as a negative electrode (23) (FIG. 2A). 1 ml of an electrolyte solution (24) of each Test Example was added to a cell (25) with a radius of 4 mm as shown in FIG. 2B. Then, a voltage shown in Table 1 was applied to a wetted part and/or a voltage application unit (A) at room temperature (23°C) for a treatment time shown in Table 1 using chronocoulometry to treat the SiC. The thickness (nm) of a film (porous film) formed by the voltage application was observed by X-SEM along a portion (B) wetted with the electrolyte. With regard to Test Examples 1 to 30, the maximum current density (mA/cm²) in the voltage application treatment and the final current density (mA/cm²) were measured, where the final current density is a current density, a variation width of which is in a range of ±3 mA/cm² continuously for 60 seconds after the voltage is applied. The results are shown in Table 1. In Table 1 below, "%" indicates "% by mass", and "DHF" indicates "hydrofluoric acid". The same applies to Tables 2 to 4 described below.

**[Table 1]**

| Test Example | Electrolyte solution | Voltage application | | Porous film formed by anodization (nm) | Maximum current density (mA/cm²) | Final current density (mA/cm²) |
|---|---|---|---|---|---|---|
| | | Voltage (V) | Treatment time (min) | | | |
| 1 | 1%DHF | 7 | 3 | 850 | 131.4 | 11.1 |
| 2 | 1%NH4F | 7 | 3 | 880 | 39.0 | 8.1 |
| 3 | 1.0%DHF+1%H5IO6 | 2.5 | 3 | 50 | 16.5 | 2.0 |
| 4 | 1.0%DHF+1%H5IO6 | 4 | 3 | 540 | 64.6 | 5.5 |
| 5 | 1.0%DHF+1%H5IO6 | 7 | 3 | 810 | 167.2 | 13.9 |
| 6 | 0.5%DHF+1%H5IO6 | 7 | 3 | 250 | 14.2 | 5.6 |
| 7 | 5.0%DHF+5%H5IO6 | 7 | 3 | 8200 | 259.6 | 71.2 |
| 8 | 1.0%DHF+10ppm H5IO6 | 7 | 3 | 750 | 123.4 | 7.3 |
| 9 | 1.0%DHF+0.1%H5IO6 | 7 | 3 | 700 | 125.2 | 8.2 |
| 10 | 1%DHF+1.0%Acetic acid | 7 | 3 | 620 | 73.0 | 5.8 |
| 11 | 1%DHF+10%Acetic acid | 7 | 3 | 800 | 17.8 | 5.4 |
| 12 | 1%DHF+80%Acetic acid | 7 | 3 | 1100 | 27.5 | 8.7 |
| 13 | 1%DHF+0.1%H2SO4 | 7 | 3 | 700 | 117.4 | 7.5 |
| 14 | 1%DHF+0.1%H3P04 | 7 | 3 | 700 | 120.6 | 7.2 |
| 15 | 1%DHF+1%Ammonium acetate | 7 | 3 | 700 | 116.6 | 6.3 |
| 16 | 1%DHF+1%Triammonium citrate | 7 | 3 | 700 | 104.1 | 6.7 |
| 17 | 1%DHF+0.1%NH40H | 7 | 3 | 730 | 91.5 | 5.8 |
| 18 | 1%NH4F+0.1%NH40H | 7 | 3 | 500 | 23.7 | 4.3 |
| 19 | 1%DHF+0.1%TMAH | 7 | 3 | 710 | 53.5 | 9.8 |
| 20 | 1%NH4F+0.1%TMAH | 7 | 3 | 400 | 27.4 | 4.8 |
| 21 | 0.2%NH4F+3%H5I06 | 7 | 3 | 150 | 10.4 | 4.7 |
| 22 | 1.0%TMAF+1%H5I06 | 7 | 3 | 100 | 126.1 | 1.8 |
| 23 | 1.0%H2SiF6+1%H5IO6 | 7 | 3 | 350 | 252.6 | 1.3 |
| 24 | 1.0%DHF +1%H5IO6+1%Acetic acid | 7 | 3 | 540 | 19.9 | 8.6 |
| 25 | 1.0%DHF +1%H5IO6+200ppmSurfactant | 7 | 3 | 620 | 32.1 | 6.1 |
| 26 | 1%DHF+1%Acetic acid +200ppmSurfactant | 7 | 3 | 770 | 29.2 | 6.7 |
| 27 | 1%DHF+0.1%NH40H +200ppmSurfactant | 7 | 3 | 820 | 41.1 | 6.3 |
| 28 | 1%DHF+0.1%NH40H +10%Glycerin | 7 | 3 | 850 | 47.2 | 8.6 |
| 29 | 1%DHF+0.1%TMAH +200ppmSurfactant | 7 | 3 | 660 | 56.3 | 7.2 |
| 30 | 1%DHF+0.1%TMAH +10%Glycerin | 7 | 3 | 580 | 28.5 | 6.2 |

As is clear from the results shown in Table 1, in each of Test Examples 1 to 30, a porous film could be formed on a desired surface of the silicon carbide single crystal substrate in a short time under mild conditions such as room temperature.

### [Treatment (2) of SiC Substrate]

A porous film was removed from the SiC substrate, on which the porous film had been formed in [Treatment (1) of SiC Substrate], by the treatment method shown in Table 2. Crosssection observation was performed by X-SEM, and a sample from which the porous film had been removed was evaluated as "O" (good), and a sample from which the porous film had not been removed was evaluated as "X" (poor). The results are shown in Table 2. Conditions of each treatment method are shown below. Wet Etching: treatment with 5% HF at room temperature (23°C) for 10 minutes.
Dry Etching: CF₄/O₂ = 90/10 sccm or CF₄ = 100 sccm, RF = 1,200 W, Bias 200 W. Treatment at room temperature (23°C) for 3 minutes.
Ashing: CF₄/O₂ = 50/100 sccm, RF = 1,200W. Treatment at 80°C for 3 minutes.
CMP: 30 minute polishing using a suspension (slurry) in which colloidal silica having a particle diameter of 85 nm was dispersed in ammonia water or KOH (concentration of colloidal silica: 10%).

**[Table 2]**

| Test Example | Electrolyte solution | Porous film removal evaluation | | | |
|---|---|---|---|---|---|
| | | Wet etching | Dry etching | Ashing | CMP |
| 1 | 1%DHF | × | ○ | ○ | ○ |
| 2 | 1%NH4F | × | ○ | ○ | ○ |
| 3 | 1.0%DHF+1%H5IO6 | × | ○ | ○ | ○ |
| 4 | 1.0%DHF+1%H5IO6 | × | ○ | ○ | ○ |
| 5 | 1.0%DHF+1%H5IO6 | × | ○ | ○ | ○ |
| 6 | 0.5%DHF+1%H5IO6 | × | ○ | ○ | ○ |
| 7 | 5.0%DHF+5%H5IO6 | × | ○ | ○ | ○ |
| 8 | 1.0%DHF+10ppm H5IO6 | × | ○ | ○ | ○ |
| 9 | 1.0%DHF+0.1%H5IO6 | × | ○ | ○ | ○ |
| 10 | 1%DHF+1.0%Acetic acid | × | ○ | ○ | ○ |
| 11 | 1%DHF+10%Acetic acid | × | ○ | ○ | ○ |
| 12 | 1%DHF+80%Acetic acid | × | ○ | ○ | ○ |
| 13 | 1%DHF+0.1%H2SO4 | × | ○ | ○ | ○ |
| 14 | 1%DHF+0.1%H3PO4 | × | ○ | ○ | ○ |
| 15 | 1%DHF+1%Ammonium acetate | × | ○ | ○ | ○ |
| 16 | 1%DHF+1%Triammonium citrate | × | ○ | ○ | ○ |
| 17 | 1%DHF+0.1%NH4OH | × | ○ | ○ | ○ |
| 18 | 1%NH4F+0.1%NH4OH | × | ○ | ○ | ○ |
| 19 | 1%DHF+0.1%TMAH | × | ○ | ○ | ○ |
| 20 | 1%NH4F+0.1%TMAH | × | ○ | ○ | ○ |
| 21 | 0.2%NH4F+3%H5IO6 | × | ○ | ○ | ○ |
| 22 | 1.0%TMAF+1%H5IO6 | × | ○ | ○ | ○ |
| 23 | 1.0%H2SiF6+1%H5IO6 | × | ○ | ○ | ○ |
| 24 | 1.0%DHF +1%H5IO6+1%Acetic acid | × | ○ | ○ | ○ |
| 25 | 1.0%DHF +1%H5IO6+200ppmSurfactant | × | ○ | ○ | ○ |
| 26 | 1%DHF+1%Acetic acid +200ppmSurfactant | × | ○ | ○ | ○ |
| 27 | 1%DHF+0.1%NH4OH +200ppmSurfactant | × | ○ | ○ | ○ |
| 28 | 1%DHF+0.1%NH4OH +10%Glycerin | × | ○ | ○ | ○ |
| 29 | 1%DHF+0.1%TMAH +200ppmSurfactant | × | ○ | ○ | ○ |
| 30 | 1%DHF+0.1%TMAH +10%Glycerin | × | ○ | ○ | ○ |

As is clear from the results shown in Table 2, it can be seen that each porous film of Test Examples 1 to 30 formed on the SiC substrate by the method of the present invention could be satisfactorily removed by any of dry etching, ashing, or CMP. On the other hand, it can be said that the porous film formed on the SiC substrate by the method of the present invention had poor removability by wet etching.

### (Qualitative Analyses of Porous Films)

A SiC wafer (having a silicon carbide semiconductor layer epitaxially grown on the first main surface manufactured by Showa Denko) was anodized under the conditions shown in Table 3 to form a porous film having a thickness of 810 nm. In Test Examples 34 and 35, the porous films were further removed under the conditions shown in Table 3. For each Test Example, the treated SiC wafer surface was subjected to qualitative analysis by Rutherford backscattering spectrometry (RBS analysis). The results are shown in Table 3. In the untreated SiC wafer of Test Example 31, Si:C = 50:50 (%).

**[Table 3]**

| Test Example | Porous film formation | | | | Porous film removal | RBS analysis results | | |
|---|---|---|---|---|---|---|---|---|
| | Electrolyt e solution | Voltage application | | | | | | |
| | | Temperatur e (°C) | Voltage (V) | Treatment time (min) | | Si (%) | O (%) | C (%) |
| 31 | - | - | - | - | - | 50 | - | 50 |
| 32 | 1%DHF | 23 | 7 | 3 | - | 34 | 6 | 60 |
| 33 | 1%DHF +1%H₅IO₆ | 23 | 7 | 3 | - | 33 | 9 | 58 |
| 34 | 1%DHF +1%H₅IO₆ | 23 | 7 | 3 | CF₄/O₂ Ashing, 80°C 3min | 50 | - | 50 |
| 35 | 1%DHF +1%H₅IO₆ | 23 | 7 | 3 | CF₄/O₂Dry etching, 23°C 3min | 50 | - | 50 |

From the results shown in Table 3, it was confirmed that carbon-rich porous films were formed in the SIC substrates (Test Examples 32 and 33) subjected to anodization treatment with an electrolyte solution containing a fluorine anion. In Test Examples 34 and 35 in which the porous film removal treatment was performed, it was confirmed that the component ratios of the SiC substrates were the same as that of the untreated SiC substrate of Test Example 31. By observing cross-sections of the SiC substrates of Test Examples 34 and 35 by X-SEM, it was confirmed that the porous films formed by the anodization treatment had been removed.

### [Evaluation of Bubble Formation]

Using the electrolyte solution of each Test Example shown in Table 4, a SiC wafer (having a silicon carbide semiconductor layer epitaxially grown on the first main surface manufactured by Showa Denko) was subjected to an anodization treatment at room temperature (23°C) under conditions of a voltage of 7 V and a treatment time of 3 minutes in the same manner as in [Treatment (1) of SiC Substrate]. In each Example, the formation of a porous film by anodic oxidation treatment was confirmed. After the anodization treatment, the presence or absence of bubble formation on each SiC substrate was visually evaluated, and a sample without bubble formation was evaluated as "O" (good), and a sample with bubble formation was evaluated as "X" (poor). The results are shown in Table 4.

**[Table 4]**

| Test Example | Electrolyte solution | Bubbles |
|---|---|---|
| 11 | 1%DHF+10%Acetic acid | × |
| 26 | 1%DHF+1%Acetic acid +200ppmSurfactant | ○ |
| 17 | 1%DHF+0.1%NH4OH | × |
| 27 | 1%DHF+0.1%NH4OH +200ppmSurfactant | ○ |
| 28 | 1%DHF+0.1%NH4OH +10%Glycerin | ○ |
| 19 | 1%DHF+0.1%TMAH | × |
| 29 | 1%DHF+0.1%TMAH +200ppmSurfactant | ○ |
| 30 | 1%DHF+0.1%TMAH +10%Glycerin | ○ |

As is clear from the results shown in Table 4, bubble formation occurred in Test Examples 11, 17, and 19 in which the electrolyte solution did not contain an antifoaming agent. On the other hand, it can be seen that in Test Examples 26 to 30 in which the electrolyte solution contained an antifoaming agent, bubble formation could be suppressed.

### EXPLANATION OF REFERENCE NUMERALS

1 Anode
2 Cathode
4 Electrolyte solution
5 Electrolysis bath
6 Power source
7 Power source controller
8 Seal
9 Porous film
10 Porous film removal treatment device
100 Silicon carbide single crystal substrate treating system

## Claims

1. A method for treating a silicon carbide single crystal substrate, comprising:
a step (A) of providing a silicon carbide single crystal substrate having a silicon carbide semiconductor layer epitaxially grown on a first main surface thereof,
a step (B) of forming a film comprising oxygen on the first main surface by anodization using the silicon carbide single crystal substrate as an anode and applying a voltage while bringing the first main surface into contact with an electrolyte solution comprising a fluorine anion, and
a step (C) of removing the film by any of dry etching, ashing, or CMP.

2. The method for treating a silicon carbide single crystal substrate according to claim 1, wherein a fluorine anion-supply source is at least one selected from the group consisting of hydrofluoric acid, ammonium fluoride, a mixture of hydrofluoric acid and ammonium fluoride, tetramethylammonium fluoride, and hexafluorosilicic acid.

3. The method for treating a silicon carbide single crystal substrate according to claim 1, wherein the electrolyte solution comprises at least one selected from the group consisting of an acid and hydrogen peroxide.

4. The method for treating a silicon carbide single crystal substrate according to claim 3, wherein the acid is at least one selected from the group consisting of a carboxylic acid, a sulfonic acid, a phosphonic acid, an inorganic acid, and periodic acid.

5. The method for treating a silicon carbide single crystal substrate according to claim 1, wherein the electrolyte solution comprises at least one selected from the group consisting of sulfuric acid, methanesulfonic acid, an alkylsulfonic acid, phosphoric acid, polyphosphoric acid, and an alkylphosphonic acid.

6. The method for treating a silicon carbide single crystal substrate according to claim 1, wherein the electrolyte solution comprises at least one alkali selected from the group consisting of an inorganic alkali and an organic alkali.

7. The method for treating a silicon carbide single crystal substrate according to claim 6, wherein the alkali is at least one selected from the group consisting of a quaternary ammonium hydroxide salt, a tertiary amine, a secondary amine, a primary amine, and ammonia.

8. The method for treating a silicon carbide single crystal substrate according to claim 1, wherein the electrolyte comprises an oxidizing agent.

9. The method for treating a silicon carbide single crystal substrate according to claim 1, wherein the dry etching or the ashing comprises etching with a gas comprising a halogen atom.

10. The method for treating a silicon carbide single crystal substrate according to claim 1, wherein the electrolyte solution comprises at least one antifoaming agent selected from the group consisting of an organic solvent and a surfactant.

11. The method for treating a silicon carbide single crystal substrate according to claim 10, wherein the antifoaming agent comprises an alcohol solvent.

12. The method for treating a silicon carbide single crystal substrate according to claim 1, wherein the step (B) is performed at a liquid temperature of the electrolyte solution of 300°C or less.

13. The method for treating a silicon carbide single crystal substrate according to any one of claims 1 to 12, further comprising a step (D) of replenishing the electrolyte solution with a replenishing liquid having a higher fluorine anion concentration than the electrolyte solution.

14. A silicon carbide single crystal substrate treating system comprising:
an anode that is a silicon carbide single crystal substrate having an epitaxially grown silicon carbide semiconductor layer on a first main surface thereof;
a cathode opposed to the silicon carbide single crystal substrate;
an electrolyte solution interposed between the silicon carbide single crystal substrate and the cathode, being in contact with the first main surface and the cathode, and comprising a fluorine anion;
a power source device connected between the anode and the cathode and causing an anodization reaction at an interface of the first main surface by application of a voltage, and
a treatment device that removes a film comprising oxygen formed on the first main surface by any of dry etching, ashing or CMP.

15. A replenishing liquid for use in replenishing the electrolyte solution for use in the method for treating a silicon carbide single crystal substrate according to claim 1,
wherein the replenishing liquid has a higher fluorine anion concentration than the electrolyte solution.
